(19) Europäisches Patentamt
European Patent Office
Office européen des brevets

(11) **EP 4 231 061 B1**

(12) **FASCICULE DE BREVET EUROPEEN**

(45) Date de publication et mention
de la délivrance du brevet:
**07.05.2025 Bulletin 2025/19**

(21) Numéro de dépôt: **23157453.4**

(22) Date de dépôt: **20.02.2023**

(51) Classification Internationale des Brevets (IPC):
***G02B 1/118*** (2015.01)

(52) Classification Coopérative des Brevets (CPC):
**G02B 1/118**

(54) **DISPOSITIF OPTO-ÉLECTRONIQUE À STRUCTURE ANTI-REFLET SUB-LONGUEUR D'ONDE, ÉCRAN ET PROCÉDÉ DE FABRICATION ASSOCIÉS**

OPTOELEKTRONISCHE VORRICHTUNG MIT SUBWELLENLÄNGEN-ANTIREFLEXSTRUKTUR, ANZEIGE UND HERSTELLUNGSVERFAHREN DAFÜR

OPTOELECTRONIC DEVICE WITH SUB-WAVELENGTH ANTIREFLECTION STRUCTURE, ASSOCIATED SCREEN AND MANUFACTURING METHOD

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **21.02.2022 FR 2201498**

(43) Date de publication de la demande:
**23.08.2023 Bulletin 2023/34**

(73) Titulaire: **Commissariat à l'Energie Atomique et aux Energies Alternatives
75015 Paris (FR)**

(72) Inventeurs:
• **NDIAYE, Amade**
**38054 GRENOBLE CEDEX 09 (FR)**
• **BEN BAKIR, Badhise**
**38054 GRENOBLE CEDEX 09 (FR)**

(74) Mandataire: **Cabinet Camus Lebkiri
25 rue de Maubeuge
75009 Paris (FR)**

(56) Documents cités:
**US-A1- 2014 211 302    US-B2- 7 145 721**

**Description**

**DOMAINE TECHNIQUE**

Le domaine technique est celui de la micro-électronique, plus particulièrement celui des dispositifs opto-électroniques d'émission de lumière, tels que les diodes électroluminescentes, par exemple.

**ARRIERE-PLAN TECHNOLOGIQUE**

Les sources lumineuses à base de semi-conducteurs, tels que les diodes électroluminescentes ou les diodes lasers, sont de plus en plus utilisées et connaissent un développement soutenu depuis de nombreuses années.

Dernièrement, des avancées importantes ont été réalisées dans le domaine des microLEDs et écrans à microLEDs, ainsi que dans le domaine des LEDs de plus grandes dimensions (et de plus forte puissance) destinées à l'éclairage.

Quoiqu'il en soit, pour les structures émissives dites « à émission par la surface », comme les LEDs (pour « Light Emiting Diode », en anglais), ou les VCSELs (pour « Vertical-Cavity Surface-Emitting Laser », en anglais), un enjeu important est de limiter les rétro-réflexions au niveau de la surface de sortie du rayonnement.

En effet, le ou les matériaux semiconducteurs formant ces structures émissives ont des indices optiques qui sont généralement beaucoup plus élevés que l'indice optique du milieu dans lequel sort le rayonnement, par exemple de l'air (ou un matériau de remplissage transparent, comme de l'oxyde de silicium).

Sans précautions particulières, cette forte différence d'indices cause une réflexion importante au niveau de la surface de sortie de la structure émissive, pour le rayonnement produit, et cela même en incidence normale, réduisant ainsi la quantité de lumière finalement délivrée par la structure.

Pour réduire le coefficient de réflexion, la structure émissive présente au niveau de cette surface de sortie, une couche anti-reflet, formée d'un matériau homogène d'indice $n_{AR}$, qui peut être déposée sur cette surface. Une transmission maximale est obtenue lorsque la couche anti-reflet a une épaisseur égale à d'épaisseur $\lambda/(4.n_{AR})$, et lorsque l'indice $n_{AR}$ est égal à $\sqrt{n.n_{out}}$, n étant l'indice optique moyen de la structure émissive, $n_{out}$ étant l'indice du milieu dans lequel sort le rayonnement lumineux, et $\lambda$ étant la longueur d'onde moyenne du rayonnement émis (longueur d'onde dans le vide).

En pratique, on choisit, parmi les différents matériaux envisageables (matériaux qui doivent être transparents et adaptés à un dépôt en couche mince), celui dont l'indice est le plus proche de la valeur optimale $\sqrt{n.n_{out}}$. Mais en général, l'indice de ce matériau n'est pas tout à fait égal à cette valeur optimale, si bien qu'une réflexion résiduelle plus ou moins importante persiste, au niveau de la surface de sortie.

Dans ce contexte, l'article "Improved Device Performance of AlGaInP-Based Vertical Light-Emitting Diodes with Low-n ATO Antireflective Coating Layer", de Hee Kwan Lee et al., Microelectronic Engineering, 104 (1er Avril 2013), pp 29-32 décrit une LED dont la face de sortie est pourvue d'une couche anti-reflet formée par une couche mince, poreuse, en ATO (oxyde d'étain et d'antimoine ; «antimony tin oxyde »).

Cette couche, de 90 nm d'épaisseur, est formée de nanocolonnes d'ATO, inclinées, ayant chacune un diamètre compris entre environ 10 et 30 nm, séparées par de l'air, et agencées de manière désordonnée sur la face de sortie de la LED (voir la l'image 1b de l'article en question). Cette couche est obtenue en réalisant un dépôt en phase vapeur (par pulvérisation magnétron - RF magnetron sputtering), avec un flux très incliné par rapport à la surface de la structure émissive. Pour certaines conditions de pression et d'inclinaison, on observe une auto-organisation de l'ATO déposé, qui s'auto-organise sous forme colonnaire.

La longueur d'onde d'émission de la LED, $\lambda$, est d'environ 635 nm, et l'indice n de la couche supérieure de la LED, en GaP, est de 3,3 environ à cette longueur d'onde. Les dimensions typiques des nanostructures de la couche d'ATO sont donc inférieures, et même très inférieures à $\lambda/(2n)$, si bien que la couche peut être considérée, sur le plan optique, comme équivalente (au moins en première approximation) à une couche homogène, dont l'indice effectif, uniforme, a une valeur intermédiaire entre l'indice de l'air et l'indice de l'ATO.

Cette couche permet d'augmenter d'environ 20% la puissance lumineuse effectivement délivrée par la LED, par rapport à une LED sans couche anti-reflet (pour un même courant électrique traversant la LED).

L'indice effectif $n_{eff}$ de cette couche d'ATO peut être ajusté, dans une certaine mesure, en faisant varier l'inclinaison de flux (ce qui modifie la porosité de la couche d'ATO), lors du dépôt de la couche. Cela permet d'ajuster cet indice pour se rapprocher de la valeur optimale $\sqrt{n.n_{air}}$.

Ce type de couche anti-reflet a toutefois un certain nombre de limites.

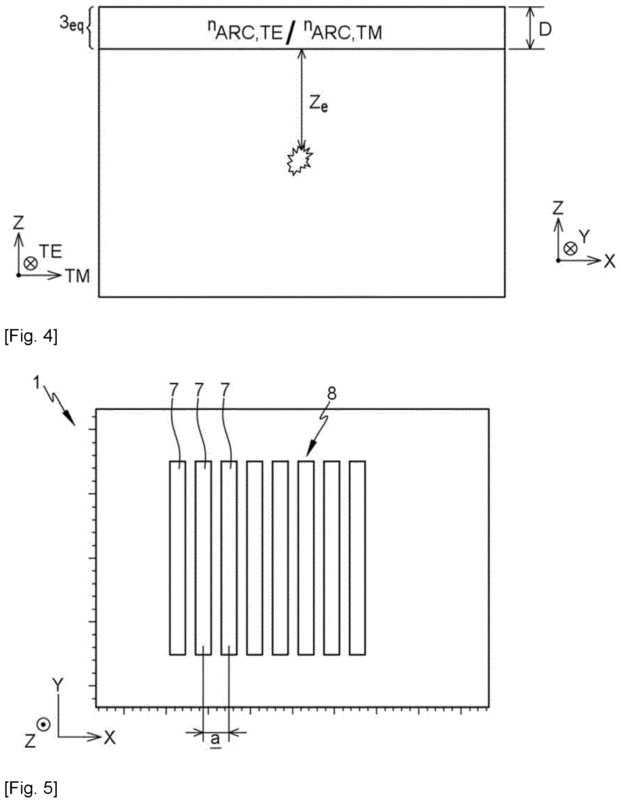

Tout d'abord, le rayonnement finalement émis dans l'air est réparti sur un angle d'émission très large (largeur totale à mi-hauteur d'environ 120 degrés ; voir la figure 4 de l'article de Hee Kwan Lee mentionné ci-dessus). La larguer angulaire du cône d'émission est d'ailleurs sensiblement la même avec cette couche anti-reflet que sans. Or, pour certaines applications, en particulier pour l'affichage de haute résolution (notamment pour la réalité augmentée et la réalité virtuelle), il est souhaitable de concentrer l'émission dans un cône relativement fermé, ayant par exemple une ouverture de plus ou moins 30 degrés, ou même de plus ou moins 15 degrés (i.e. : 15 degrés de chaque côté, soit une ouverture totale de 30 degrés), car la lumière située hors d'un tel cône d'émission n'atteindra pas l'œil de l'observateur, ou risque de créer des images fantômes.

Par ailleurs, le procédé de fabrication de cette couche est basé sur des techniques de fabrication différentes de celles employées généralement pour l'intégration planaire de structures de dimensions microniques, et peu adaptées pour un telle intégration planaire (notamment à cause de la nécessité d'incliner fortement l'échantillon).

D'autre part, ce type de fabrication, basé sur une auto-organisation du matériau déposé, ne permet de contrôler qu'une partie des caractéristiques de la couche nanostructurée, en l'occurrence son épaisseur (via un contrôle de la durée de dépôt), et, dans une moindre mesure, sa porosité (via un contrôle de l'inclinaison du flux). Mais, pour une telle couche, on ne peut contrôler ni la forme, ni les dimensions (en tout cas pas indépendamment de la porosité), ni le type de répartition de ces nanostructures colonnaires.

Enfin, la structure de cette couche est désordonnée, aléatoire. Pour des LEDs de grande dimension, telle que celle décrite dans l'article de Hee Kwan Lee mentionné ci-dessus (LED ayant une face de sortie de 1 mm$^2$), les caractéristiques de la couche anti-reflet sont bien définies, et reproductibles, car elles correspondent à une moyenne sur un très grand nombre de nanocolonnes. En revanche, pour des microLEDs, dont la surface d'émission peut être de seulement 5 microns carrés, par exemple (et même parfois moins), les caractéristiques d'une telle couche anti-reflet peuvent varier substantiellement, de manière non contrôlée, d'une microLED à l'autre. En effet, le nombre de nanocolonnes présentes sur la face de la microLED, ou leur diamètre, peut fluctuer substantiellement d'une microLED à l'autre, car l'effet de moyennage (de lissage) mentionné plus haut est beaucoup moins important qu'avec une LED de grande dimension. Cette disparité des caractéristiques de la couche, d'une micro-LED à l'autre peut alors de traduire par une inhomogénéité de luminosité et donc une sorte de bruit d'affichage indésirable, pour un écran à microLED. Les documents US 2014/211302 A1 et US 7 145 721 B2 sont pertinent pour la présente invention.

## RESUME

Pour remédier au moins en partie aux limites de l'art antérieur, la présente technologie concerne alors un dispositif opto-électronique comprenant :

- une structure émissive :

  - dont une partie au moins est formée d'un ou plusieurs matériaux semi-conducteurs,
  - configurée pour produire un rayonnement lumineux lorsqu'elle est traversée par un courant électrique, ledit rayonnement lumineux étant produit au sein de la structure émissive et ayant une longueur d'onde moyenne λ,
  - la structure émissive ayant un indice optique moyen n et étant délimitée par une surface de sortie, par laquelle sort une partie au moins dudit rayonnement lumineux, et

- une structure anti-reflet, située au niveau de la surface de sortie,
- dans lequel la structure anti-reflet comprend un réseau périodique sub-longueur d'onde qui comporte des parties en creux et des parties en saillie formant une structure périodique régulière de pas (a) inférieur à /[2.n].

Les inventeurs ont constaté qu'une couche anti-reflet avec une structuration sub-longueur d'onde (nanométrique) *régulière,* périodique, permettait de modifier l'ouverture angulaire du cône d'émission (cône d'émission final, dans l'air ou dans le milieu de sortie), par rapport à une structure émissive sans couche anti-reflet, contrairement à la structure *désordonnée* de l'article de Hee Kwan Lee mentionné plus haut (qui ne modifie pas cette ouverture angulaire). Des résultats de simulation numérique, présentés plus bas lors de la description des figures, illustrent cet effet, en l'occurrence dans le cas d'une réduction de l'ouverture angulaire du cône d'émission. L'émission se trouve alors concentrée dans un cône d'émission plus fermé, ce qui est intéressant pour différents types d'applications.

On notera que le réseau qui forme cette structure anti-reflet n'est pas un réseau diffractif. En effet, son pas a, c'est-à-dire sa période spatiale, est inférieur à λ/(2n). Son spectre de fréquences spatiales est donc situé entièrement au-dessus de la fréquence de coupure limite (2n)/λ, au-delà de laquelle il n'y a plus d'effets diffractifs (ou d'effets de résonance). Ce réseau ne donne notamment pas lieu à des effets de diffraction en champ lointain, et son fonctionnement est bien différent d'un réseau diffractif. On notera à ce sujet que, pour ce réseau, le pas a est bien inférieur à λ/(2n), et non pas simplement inférieur à λ ou même λ/2 (il est donc bien différent, entre autres, d'un réseau diffractif dont le pas est inférieur à λ mais supérieur à λ/[2n] - qui, en l'occurrence, est un réseau *diffractif,* mais pour lequel seul l'ordre 0 est transmis, en incidence normale). L'effet du réseau sub-longueur d'onde en question doit ainsi être analysé plutôt en termes de milieu effectif moyen, comme si la structure antireflet était formée d'un matériau homogène. L'expression « réseau réfractif » (et non « réseau diffractif ») est d'ailleurs parfois employée pour désigner un tel réseau, dans ce domaine technique.

Le fait qu'un tel réseau modifie la directivité du rayonnement émis, alors que son fonctionnement doit plutôt être analysé en termes de milieu effectif homogène, est donc surprenant à première vue. Une explication possible de cet effet (dont le détail a lieu a priori à petite échelle, et est probablement complexe), est que le milieu effectif moyen en question a des propriétés différentes selon qu'il est vu en incidence normale, ou sous une incidence non nulle, ce qui pourrait expliquer la modification de directivité en question.

Par ailleurs, employer ainsi un réseau sub-longueur régulier, réalisé typiquement par gravure, plutôt qu'une structure nano-texturée désordonnée, permet une bonne reproductibilité, d'un dispositif opto-électronique à l'autre (notamment en termes d'efficacité lumineuse et de directivité), en particulier lorsque le dispositif, micronique, est de très petite taille.

Ce type de réseau sub-longueur d'onde régulier peut être réalisé directement par lithographie puis gravure d'une face supérieure libre de la structure émissive, sans apport de matériau extérieur. En effet, pour l'indice optique effectif du réseau (i.e. : pour l'indice de la couche homogène fictive, effective, représentant le réseau), on obtient alors naturellement une valeur qui est comprise entre l'indice optique moyen de la structure émissive, et l'indice optique du milieu dans lequel sort le rayonnement. La structure anti-reflet obtenu ainsi est donc réalisée sans apport de matériau extérieur et est ainsi très stable (notamment quand la structure émissive est à base de GaN ou de l'AlGaInP), comparée notamment à une couche anti-reflet à base de matériaux organiques, qui ont des durées de vie limitée, en particulier quand il s'agit d'applications à haute luminance.

Plus généralement, une telle fabrication par lithographie et gravure (bien qu'exigeante, du fait des dimensions réduites à atteindre) s'intègre commodément dans le flux d'étapes de fabrication d'un dispositif, en particulier micronique, obtenu par des techniques planaires.

Elle permet en outre un contrôle indépendant des différentes caractéristiques du réseau. On peut ainsi ajuster non seulement son épaisseur et son facteur de remplissage, mais aussi le pas du réseau, son type de maille, la forme des motifs, le caractère uni- ou bi-dimensionnel du réseau, ou encore l'orientation des rainures (à adapter à la polarisation du rayonnement), dans le cas d'un réseau unidimensionnel.

Outre les caractéristiques mentionnées ci-dessus, le dispositif opto-électronique qui vient d'être présenté peut présenter une ou plusieurs des caractéristiques optionnelles suivantes, considérées individuellement ou selon toutes les combinaisons techniquement envisageables :

- l'aire occupée par la surface de sortie de la structure émissive est inférieure à 50 $\mu m^2$, voire inférieure à 5 $\mu m^2$ ;

- la structure émissive comporte une couche supérieure superficielle, formée d'un matériau semi-conducteur, et les parties en saillie dudit réseau, formées du même matériau semi-conducteur que ladite couche supérieure superficielle, sont d'un seul tenant avec la couche supérieure de la structure émissive ;

- les parties en saillie du réseau sont formées d'un matériau ayant un indice optique $n_p$, un milieu d'indice optique $n_{out}$ s'étend au-dessus du réseau, à l'opposé de la structure émissive, un milieu d'indice $n_r$ remplit les parties en creux du réseau ;

- un facteur de remplissage FF du réseau, égal à la fraction du volume du réseau occupé par ses parties en creux, est égal au facteur de remplissage $FF_{TE}$ donné par la formule F1 suivante :

$$\sqrt{FF_{TE}.n_r^2 + (1 - FF_{TE}).n_p^2} = \sqrt{n.n_{out}} \quad \text{(F1)};$$

- le réseau est unidimensionnel, les parties en creux étant des rainures rectilignes parallèles entre elles, et dans lequel ledit rayonnement a une polarisation substantiellement rectiligne, et parallèle auxdites rainures ;

- le réseau est un réseau bidimensionnel comportant un motif répété périodiquement selon une première direction, et répété aussi, périodiquement, selon une deuxième direction différente de la première direction ;

- le réseau est unidimensionnel, les parties en creux étant des rainures rectilignes parallèles entre elles, et ledit rayonnement a une polarisation substantiellement rectiligne et perpendiculaire auxdites rainures, et un facteur de remplissage FF du réseau, égal à la fraction du volume du réseau occupé par ses parties en creux, est égal au facteur de remplissage $FF_{TM}$ donné par la formule F2 suivante :

$$\sqrt{\left(FF_{TM}.n_r^{-2} + (1 - FF_{TM}).n_p^{-2}\right)^{-1}} = \sqrt{n.n_{out}} \quad \text{(F2)} ;$$

- le réseau a une profondeur D, selon une direction perpendiculaire à la surface de sortie, la profondeur D étant égale à $\lambda/\left(4\sqrt{n.n_{out}}\right)$, $n_{out}$ étant l'indice optique du milieu qui s'étend au-dessus du réseau, à l'opposé de la structure émissive ;

- le dispositif est une diode électroluminescente, et la structure émissive comprend :

  - une couche inférieure, formée au moins en partie d'un semi-conducteur dopé,

  - une couche supérieure, formée au moins en partie d'un semiconducteur dopé, les couches inférieure et supérieure ayant des dopages de types opposés, et

  - une partie émissive, qui s'étend entre la couche inférieure et la couche supérieure et qui est apte à émettre ledit rayonnement lumineux lorsqu'elle est traversée par un courant électrique.

La présente technologie concerne également un écran d'affichage comprenant une matrice de dispositifs opto-électroniques tels que décrits ci-dessus.

La présente technologie concerne également un procédé de fabrication d'un tel dispositif opto-électronique, comprenant :

- une étape de réalisation d'une structure émissive dont une partie au moins est formée d'un ou plusieurs matériaux semi-conducteurs, configurée pour produire un rayonnement lumineux lorsqu'elle est traversée par un courant électrique, ledit rayonnement lumineux étant produit au sein de la structure émissive et ayant une longueur d'onde moyenne $\lambda$, la structure émissive ayant un indice optique moyen n et étant délimitée par une surface de sortie, par laquelle sort une partie au moins dudit rayonnement lumineux, et

- une étape de réalisation d'une structure anti-reflet, située au niveau de la surface de sortie,

- dans lequel l'étape de réalisation de la structure anti-reflet comprend une étape de réalisation d'un réseau périodique sub-longueur d'onde qui comporte des parties en creux et des parties en saillie formant une structure périodique régulière de pas inférieur à $\lambda/[2.n]$.

Dans ce procédé, la structure émissive peut présenter, à l'issu de l'étape de réalisation de cette structure, une face supérieure libre, et le réseau peut être réalisé par lithographie électronique puis gravure de ladite face supérieure.

Les caractéristiques optionnelles, présentées plus haut en termes de dispositif, peuvent s'appliquer aussi au procédé qui vient d'être décrit.

La présente technologie et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif.

La figure 1 représente schématiquement un dispositif opto-électronique conforme à la présente technologie, vu de côté.

La figure 2 est une représentation schématique du dispositif de la figure 1, dans laquelle une structure émissive du dispositif est représentée, de manière simplifiée, par un milieu homogène.

La figure 3 correspond à une modélisation simplifiée du dispositif de la figure 1, dans laquelle une structure anti-reflet du dispositif, basée sur un réseau sub-longueur d'onde, est représentée par une couche anti-reflet effective, homogène.

La figure 4 représente schématiquement le dispositif de la figure 1, vu de dessus.

La figure 5 représente l'évolution d'un coefficient de transmission de la structure anti-reflet du dispositif de la figure 1, en fonction d'un angle d'incidence sur cette structure.

La figure 6, la figure 7 et la figure 8 montrent chacune l'efficacité d'émission du dispositif, pour un angle de collection de plus ou moins 90° (90° de chaque côté, soit tout le demi-espace), plus ou moins 30° et plus ou moins 15° respectivement, en fonction de la profondeur des motifs du réseau.

La figure 9 représente l'efficacité d'émission du dispositif, en fonction de l'angle de collection.

La figure 10 montre une variante du dispositif de la figure 1, vu de dessus.

La figure 11 montre une autre variante du dispositif de la figure 1, vu de dessus.

La figure 12 représente schématiquement des étapes d'un procédé de fabrication du dispositif de la figure 1.

## DESCRIPTION DETAILLEE

Comme mentionné plus haut, la présente technologie concerne notamment un dispositif opto-électronique, 1 ; 1'; 1", par exemple de type LED ou VCSEL, comprenant une structure émissive avec émission par la surface, ainsi qu'une structure anti-reflet favorisant la sortie du rayonnement produit dans la structure émissive, basée sur un réseau périodique sub-longueur d'onde non diffractif.

Dans la suite, on décrit tout d'abord la structure émissive en elle-même, puis cette structure anti-reflet particulière. Des résultats de simulations numériques illustrant les performances pouvant être obtenues avec cet agencement sont présentées ensuite.

Le dispositif opto-électronique, 1 ; 1'; 1" est un dispositif en semi-conducteur(s) : une partie au moins de sa structure émissive 2 est formée d'un ou plusieurs matériaux semi-conducteurs. Cette structure émissive 2 est configurée pour produire un rayonnement lumineux lorsqu'elle est traversée par un courant électrique. Ce rayonnement lumineux est produit au sein de la structure émissive, de manière interne, dans le volume de celle-ci. La structure émissive 2 est délimitée en partie supérieure par une surface de sortie 4. Une partie au moins du rayonnement produit sort de la structure émissive 2 par cette surface de sortie 4, pour se propager ensuite dans un milieu de sortie, 5, qui s'étend au-dessus de la structure émissive. La surface de sortie 4 est la surface libre de la structure émissive 2, ici en contact avec le milieu de sortie 5 (il s'agit donc d'une surface en quelque sorte dentelée, ici, du fait de la structure en réseau de cette interface). En pratique, l'indice optique $n_{out}$ du milieu de sortie (par exemple de l'air, ou un matériau de remplissage transparent d'indice inférieur à n, qui pourrait être de l'oxyde de silicium $SiO_2$ du nitrure de silicium ou de l'alumine) est généralement nettement plus petit que l'indice optique moyen n de la structure émissive 2, à base de semi-conducteur(s).

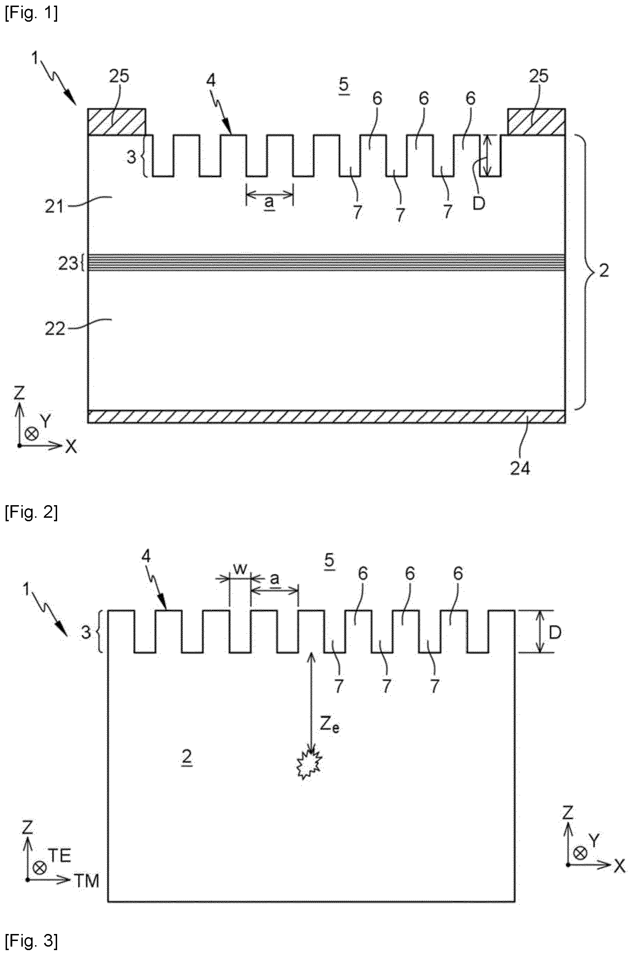

La structure émissive 2, peut, comme ici, avoir une structure planaire, la structure émissive étant alors formée par un empilement de couches 21, 22, 23 qui s'étendent parallèlement les unes aux autres. En pratique, ces couches s'étendent parallèlement à un substrat, qui sert de support au dispositif opto-électronique. La surface de sortie 4 est alors globalement parallèle à ces couches 21, 22, 23 (c'est-à-dire que le plan moyen défini par la surface de sortie 4 est parallèle aux couches, par exemple parallèle à 10 degrés près, ou mieux). Sur les figures 1 à 4, 10, et 11, on a représenté des axes X, Y et Z orthogonaux deux à deux. Le plan (X, Y) est parallèle au plan des couches, tandis que la direction perpendiculaire à la surface de sortie 4 (i.e. : la direction perpendiculaire au plan moyen défini par cette surface) est repérée par l'axe Z.

La structure émissive 2 peut comprendre (comme dans le cas de la figure 1, par exemple) :

- une couche inférieure, 22, formée au moins en partie d'un semi-conducteur dopé,

- une couche supérieure 21, formée au moins en partie d'un semiconducteur dopé, les couches inférieure et supérieure 22, 21 ayant des dopages de types opposés, et

- une partie émissive 23, qui s'étend entre la couche inférieure 22 et la couche supérieure 21 et qui est apte à émettre ledit rayonnement lumineux lorsqu'elle est traversée par un courant électrique.

Dans le mode de réalisation représenté, la partie émissive 23 comprend un empilement d'un ou plusieurs puits quantiques planaires. En variante, la partie émissive pourrait être toutefois d'un type différent ; il pourrait par exemple s'agir d'une simple jonction entre les couches supérieure et inférieure, de dopages opposés (jonction sans matériau interstitiel, par exemple).

Par « puit quantique planaire » on désigne ici une structure comprenant une couche centrale, mince (épaisseur de l'ordre de la dizaine de nanomètre), formée d'un premier matériau semi-conducteur ainsi que deux couches barrières qui enserrent la couche centrale, formée d'un autre matériau semiconducteur qui a une bande interdite plus large que la bande interdite du premier matériau. La couche centrale, mince, forme ainsi un puit de potentiel pour les électrons et/ou les trous. A titre d'exemple, pour une émission dans le rouge, on pourra réaliser la couche centrale et les couches barrières en Phosphorure d'Aluminium-Indium-Galium AlInGaP et en Phosphorure d'Indium-Gallium InGaP. Plus généralement, lorsque l'on souhaite obtenir une émission dans le domaine du visible, on pourra réaliser la couche active à partir de matériaux semi-conducteurs III-V, c'est-à-dire comprenant un élément de la colonne V du tableau périodique des éléments (N, As, P) associé à un ou plusieurs éléments de la colonne III du tableau périodique des éléments (Ga, Al, In).

Les couches inférieure 22 et supérieure 21 peuvent être chacune d'un seul tenant. Par exemple, lorsque la couche active est formée de puits en AlInGaP/InGaP, les couches inférieures et supérieures pourront être réalisées chacune sous la forme d'une couche d'un seul tenant en InGaP, dopé de type N pour l'une, et dopé de type P pour l'autre. Les couches inférieure 22 et supérieure 21 peuvent aussi être formées chacune par un empilement de plusieurs sous-couches. Et l'on peut prévoir que certaines seulement de ces sous-couches soient dopées.

Une électrode inférieure 24, conductrice (par exemple métallique), est en contact avec une face inférieure de la couche inférieure 22. Une ou plusieurs électrodes supérieures 25, conductrices (par exemple métalliques) sont en contact avec une surface supérieure de la couche supérieure 21. Comme représenté sur la figure 1, la ou les électrodes supérieures 5 occupent une partie seulement de la surface supérieure de cette couche (surface supérieure qui correspond à la surface de sortie 4 mentionnée plus haut), pour laisser sortir le rayonnement lumineux produit (elles sont par exemple situées en périphérie, ou au centre de cette surface). Les électrodes inférieure et supérieures permettent ainsi d'injecter un courant électrique dans le dispositif 1, afin de produire le rayonnement lumineux en question.

Ce rayonnement lumineux a une longueur d'onde moyenne $\lambda$ (longueur d'onde moyenne du spectre d'émission de cette structure émissive). Il s'agit de sa longueur d'onde moyenne dans le vide (ou dans un milieu d'indice égal à 1).

Lorsque la structure émissive est formée de matériaux semiconducteurs ayant des indices optiques différents, l'indice moyen n de la structure, mentionné plus haut, correspond à une moyenne (par exemple une moyenne volumique) des indices optiques des parties de la structure émissive où le rayonnement est produit et de celles qui sont traversées par ce rayonnement. Pour le mode de réalisation représenté sur la figure 1, par exemple, l'indice optique n est une moyenne des indices optiques respectifs de la couche inférieure 22, de la couche supérieure 21, et des couches formant les puits quantiques planaires de la partie émissive 23.

En pratique, l'indice optique moyen n peut être proche de l'indice optique du matériau qui forme la couche supérieure 21 (ou même égal à ce dernier).

L'indice optique moyen n, ainsi d'ailleurs que les autres indices optiques mentionnés dans ce document, sont des indices à la longueur d'onde moyenne $\lambda$.

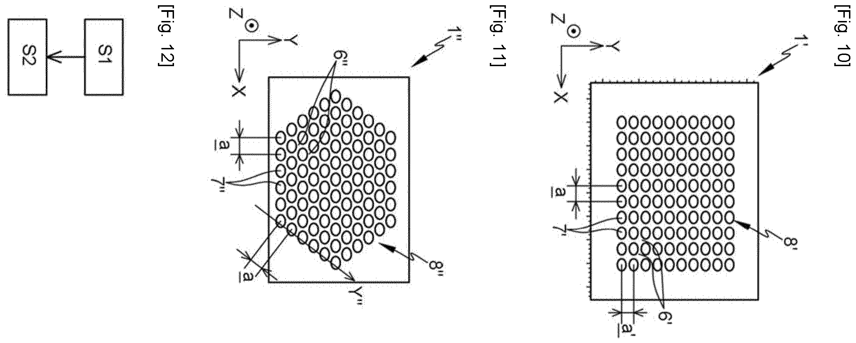

Dans le mode de réalisation de la figure 1, et dans ses variantes des figures 10 et 11, le dispositif optoélectronique 1 ; 1' ; 1" est une diode électroluminescente.

En l'occurrence, il s'agit d'une microLED, ayant des dimensions transverses microniques (ce qui permet de réaliser des écrans d'affichage ayant une résolution spatiale très élevée). Plus précisément, la surface de sortie 4 de la LED 1 ; 1' ; 1" occupe une aire inférieure à 50 $\mu m^2$ (50 microns carrés), voire inférieure à 5 $\mu m^2$. La LED 1 ; 1' ; 1" peut par exemple avoir une section (section selon un plan parallèle aux couches) rectangulaire, les côtés de ce rectangle étant inférieurs chacun à 10, ou même à 3 ou 2 microns.

Comme indiqué plus haut, la structure anti-reflet 3 du dispositif comprend un réseau 8 ; 8' ; 8" périodique sub-longueur d'onde. Ce réseau comporte des parties en creux 7 ; 7' ; 7" et des parties en saillie 6 ; 6' ; 6" formant une structure périodique régulière, de pas $\underline{a}$ inférieur à $\lambda/(2.n)$.

Les parties en saillie 6 ; 6' ; 6" font saillie à partir de la structure émissive 2, vers le milieu de sortie 5. Ici, le milieu de sortie 5 s'étend dans les parties en creux 7 ; 7' ; 7" du réseau, et remplit ces parties en creux. En variante, les parties en creux pourraient toutefois être remplies par un matériau, transparent, ayant un indice différent du milieu de sortie (la surface supérieure du matériau en question étant alors planarisée, pour obtenir une interface plane, affleurant par exemple le sommet des parties en saillie). Quoiqu'il en soit, l'indice du matériau, ou du milieu qui remplit les parties en creux est noté $n_r$. Lorsque le milieu de sortie 5 s'étend dans les parties en creux et les remplit, comme ici, on a $n_r = n_{out}$ (par exemple égal à $n_{air}$).

Le réseau est formé par la répétition périodique d'un motif donné, par exemple un trou 7' ; 7" ou une rainure 7 gravée sur la surface supérieure de la structure émissive 2, ou une nano-colonne s'étendant de la structure émissive vers le milieu de sortie.

On notera que le réseau 8 ; 8' ; 8" est dépourvu de parties métalliques : ses parties en saillie sont formées par un matériau semiconducteur, ou diélectrique (et le milieu de sortie, qui occupe les parties en creux, est un milieu diélectrique).

Le matériau, dans lequel sont formées les parties en saillie 6 ; 6' ; 6" du réseau, a un indice optique noté $n_p$.

Le réseau peut être réalisé en gravant directement la surface supérieure, c'est-à-dire la surface de sortie de la structure émissive 2. Le matériau (en pratique un matériau semiconducteur), dans lequel sont formées les parties en saillie 6 ; 6' ; 6" du réseau, est alors le même que pour la couche supérieure 21 de la structure émissive (ou le même que pour la sous-couche la plus superficielle de la couche supérieure, si cette souche est formée de plusieurs sous-couches), et ces parties en saillie sont d'un seul tenant avec cette couche supérieure (c'est-à-dire sans discontinuité de matière). Dans ce cas, l'indice optique $n_p$ des parties en saillie est le même que pour cette couche supérieure. Il est alors proche de, ou même égal à l'indice moyen n de la structure émissive. Pour le mode de réalisation de la figure 1, on peut d'ailleurs considérer que $n_p=n$.

Réaliser le réseau de cette manière permet, pour l'indice optique effectif du réseau, d'obtenir commodément une valeur intermédiaire entre l'indice moyen n de la structure émissive, et l'indice $n_{out}$ du milieu de sortie (puisque les parties en saillie ont alors un indice n, ou proche de n, tandis que les parties en creux ont un indice $n_{out}$).

Le réseau pourrait toutefois être réalisé en déposant une couche en matériau diélectrique ou semiconducteur sur une face supérieure de la structure émissive, puis en gravant la couche ainsi déposée. Dans ce cas, le matériau formant les parties en saillie du réseau pourrait être différent du matériau formant la couche la plus superficielle de la structure émissive.

Le réseau 8 peut être un réseau unidimensionnel, comme dans le cas du dispositif 1 de la figure 1 (représenté aussi vu de dessus sur la figure 4). Les parties en creux 7 sont alors des rainures rectilignes parallèles entre elles. Pour cet exemple, les rainures sur des rainures de section rectangulaire (rainure en U).

Le réseau 8' ; 8" peut aussi être un réseau bidimensionnel, comportant un motif 7' ; 7" répété périodiquement selon une première direction X, avec le pas a, et répété aussi, périodiquement, selon une deuxième direction Y ; Y" différente de la première direction.

La figure 10 représente une première variante, 1', du dispositif de la figure 1, vue de dessus. Pour cette variante, le réseau 8' est un réseau bidimensionnel, en l'occurrence un réseau rectangulaire, de pas a selon la direction X et de pas a' selon la direction Y, pour lequel le motif répété est un trou cylindrique 7'.

La figure 11 représente une deuxième variante, 1", du dispositif de la figure 1, vue de dessus. Le réseau 8" est là aussi un réseau bidimensionnel, en l'occurrence un réseau triangulaire, de pas a selon la direction X et de pas a selon une direction Y" (inclinée de 60 degrés par rapport à la direction X). Le motif répété est, là aussi, un trou cylindrique 7".

D'autre types de réseaux bidimensionnels périodiques, par exemple à maille hexagonale, ou correspondant à un pavage d'Archimède pourraient être employés, en variante.

Compte tenu des dimensions très petites du motif du réseau, un motif de type trou conduira en général à un dispositif plus robuste qu'un motif de type nano-colonne.

La profondeur du réseau 8 ; 8' ; 8" est notée D. Il s'agit de la distance, mesurée selon la direction Z, entre le fond des parties en creux 7 et le sommet des parties en saillie 6.

Les parties en creux 7 du réseau occupent une partie du volume total occupé par le réseau, avec un facteur de remplissage noté FF (parfois appelé « Filing Factor », ou « air Filing Factor » en anglais). Ce facteur de remplissage est égal à la fraction du volume total du réseau occupé par ses parties en creux 7.

Lorsque les motifs du réseau ont, comme ici, des flancs droits (perpendiculaires au plan moyen défini par la surface de sortie 4), ce facteur de remplissage, volumique, est égal à un facteur de remplissage surfacique, qui est égal à la fraction de la surface totale du réseau occupée par ses parties en creux 7. Dans le cas du réseau de la figure 1, comme le réseau est unidimensionnel, le facteur de remplissage FF s'exprime alors comme w/a, où w est la largeur des parties en creux 7.

Comme expliqué dans la partie intitulée « résumé », ce réseau, dont le pas a est inférieur à $\lambda/(2n)$, n'est pas un réseau diffractif, et, au moins en première approximation, son effet s'interprète comme celui d'un milieu effectif $3_{eq}$, homogène, dont l'indice a une valeur intermédiaire entre $n_p$ (indice du matériau pour les parties en saillie) et $n_r$ (indice pour les parties en creux).

Le pas limite en dessous duquel il n'y a plus d'effets diffractifs est $\lambda/(2n)$, mais le réseau en question peut avoir un pas encore plus petit, par exemple inférieur à $\lambda/(4n)$, ou même $\lambda/(8n)$ (la modélisation par un milieu effectif homogène sera d'ailleurs meilleure que le pas du réseau est petit).

Pour le réseau unidimensionnel de la figure 1, on peut considérer (en première approximation) que l'indice effectif de la couche que forme le réseau est donné :

- par la formule suivante, dans le cas d'une polarisation de type TE (polarisation « transverse électrique » ; polarisation - du champ électrique - linéaire et parallèle aux rainures du réseau) :

$$n_{ARC,TE} = \sqrt{FF.n_r^2 + (1 - FF).n_p^2}$$

- et par la formule suivante, dans le cas d'une polarisation de type TM (polarisation « transverse magnétique » ; polarisation linéaire et perpendiculaire aux rainures du réseau) :

$$n_{ARC,TM} = \sqrt{\left(FF.n_r^{-2} + (1 - FF).n_p^{-2}\right)^{-1}}$$

Le réseau peut donc être dimensionné de manière à ce que son indice effectif, $n_{ARC,TE}$ ou $n_{ARC,TM}$ selon le cas, soit égal à l'indice pour lequel une couche anti-reflet homogène est la plus performante, en termes d'effet anti-reflet, c'est-à-dire égal à $\sqrt{n.n_{out}}$ .

Lorsque la structure émissive produit un rayonnement lumineux dont la polarisation est sensiblement linéaire (ce qui est le cas généralement pour une LED à puits quantiques telle que décrite plus haut ; la polarisation du champ électrique étant alors généralement parallèle aux couches épitaxiales), et lorsque les rainures du réseau sont parallèles à cette polarisation, on pourra donc dimensionner le réseau de manière à ce que son facteur de remplissage FF soit égal au facteur de remplissage $FF_{TE}$ donné par la formule F1 suivante :

$$\sqrt{FF_{TE}.n_r^2 + (1 - FF_{TE}).n_p^2} = \sqrt{n.n_{out}} \qquad (F1)$$

Et lorsque le rayonnement produit a une polarisation sensiblement linéaire, perpendiculaire aux rainures du réseau, on pourra dimensionner le réseau de manière à ce que son facteur de remplissage FF soit égal au facteur de remplissage $FF_{TM}$ donné par la formule F2 suivante :

$$\sqrt{\left(FF_{TM}.n_r^{-2} + (1 - FF_{TM}).n_p^{-2}\right)^{-1}} = \sqrt{n.n_{out}} \qquad (F2)$$

Dans ce document, par égal, on entend égal à mieux que 20%, ou même 10% près. On notera d'ailleurs que les formules en question peuvent être employées pour réaliser un pré-dimensionnement, déjà très satisfaisant, affiné ensuite en réalisant des simulations numériques pour augmenter encore un peu les performances du dispositif (en termes d'efficacité lumineuse ou d'ouverture angulaire).

Par ailleurs, on considère qu'une polarisation est sensiblement linéaire lorsque la composante de ce rayonnement, polarisée linéairement, représente plus de 80% de la puissance lumineuse.

Comme indiqué plus haut, pour le mode de réalisation de la figure 1, on a $n_p$=n et $n_r$=$n_{out}$, si bien que les formules F1 et F2, qui fixent les valeurs de $FF_{TM}$ et $FF_{TE}$, prennent la forme suivante :

$$\sqrt{FF_{TE}.n^2 + (1 - FF_{TE}).n_{out}^2} = \sqrt{n.n_{out}}$$

et

$$\sqrt{(FF_{TM}.n^{-2} + (1 - FF_{TM}).n_{out}^{-2})^{-1}} = \sqrt{n.n_{out}} \ .$$

Dans le cas d'un réseau bidimensionnel, tel que celui des figures 10 et 11, on peut considérer que l'indice effectif de la couche que forme le réseau est l'indice effectif $n_{ARC,TE}$ mentionné plus haut. Aussi, dans ce cas, on pourra dimensionner le réseau de manière à ce que son facteur de remplissage FF soit égal au facteur de remplissage $FF_{TE}$ mentionné ci-dessus.

Par analogie avec une couche anti-reflet homogène, la profondeur D du réseau pourra, comme ici, être choisie égale à :

- $\lambda/(4n_{ARC,TE})$, dans le cas d'un réseau bidimensionnel, ou d'un réseau unidimensionnel avec polarisation de type TE, et

- $\lambda/(4n_{ARC,TM})$, dans le cas d'un r réseau unidimensionnel avec polarisation de type TM.

Lorsque le facteur de remplissage est ajusté comme indiqué plus haut, de sorte que l'indice effectif du réseau ($n_{ARC,TE}$ ou $n_{ARC,TM}$ selon le cas) soit égal $\sqrt{n.n_{out}}$ , la profondeur D du réseau sera alors égale à

$$\lambda/\left(4\sqrt{n.n_{out}}\right).$$

Les simulations numériques présentées plus bas montrent que les critères de dimensionnement qui viennent d'être présentés (pour le facteur de remplissage FF, et pour l'épaisseur D), basés sur une analyse en termes de milieu effectif moyen, conduisent effectivement à un effet anti-reflet très efficace. Ces simulations numériques montrent aussi que ce type de réseau modifie la directivité du rayonnement produit (ce qui était en revanche difficilement prévisible par une analyse de type milieu effectif, en tout cas à première vue).

La figure 5 montre des coefficients de transmission $T_{TE}$ et $T_{TM}$ (coefficients de transmission en puissance), calculés par simulation numérique (de type RCWA, pour « rigorous coupled-wave analysis », en anglais), pour le dispositif de la figure 1, avec les paramètres suivants : a = 30 nm, λ = 640 nm, n = $n_p$ = 3,4 (indice de l'AlGaInP à la longueur d'onde considérée), $n_{out}$=$n_r$=1. Les valeurs de D et FF, déterminées selon les critères indiqués plus haut, sont alors D = 87 nm, FF=$FF_{TE}$=77% pour la simulation réalisée avec un rayonnement polarisé de type TE, et FF=$FF_{TM}$=22% pour la simulation réalisée avec un rayonnement de type TM.

Pour ces simulations, il a été considéré par ailleurs que le rayonnement était émis, dans la structure émissive, de manière ponctuelle, à une profondeur Ze=500 nm sous la surface de sortie 4 (voir les figures 2 et 3), et la structure émissive a été assimilée à un milieu homogène d'indice n, semi-infini (c'est-à-dire occupant tout le demi-espace situé sous le réseau).

Sur la figure 5, les coefficients de transmission $T_{TE}$ et $T_{TM}$ sont représentés en fonction de l'angle d'incidence $i_{INT}$ sur le réseau (angle formé avec l'axe Z), exprimé en degrés. L'angle d'incidence $i_{INT}$ est l'angle d'incidence du côté interne du dispositif, c'est-à-dire du côté d'indice n=3,4.

Sur cette figure, on a représenté aussi le coefficient de réflexion $T_{TE,O}$ et $T_{TM,O}$, correspondant à une structure émissive sans structure ou couche anti-reflet (c'est-à-dire pour une interface nue entre un milieu d'indice n=3,4 et un milieu d'indice n=1). Les coefficients $T_{TE,O}$ et $T_{TM,O}$ correspondent respectivement à un rayonnement ayant une polarisation de TE, et à un rayonnement ayant une polarisation de type TM.

Les coefficients de transmission en question sont tracés pour des valeurs de l'angle d'incidence comprises entre 0 et 17 degrés environ, qui est la valeur limite au-delà de laquelle il y a réflexion totale interne, pour une interface n=3,4 / $n_{out}$=1.

Comme on peut le voir sur cette figure, le réseau sub-longueur, dimensionné comme indiqué plus haut, permet effectivement d'annuler quasiment complètement la réflexion vitreuse à l'interface entre la structure émissive 2 et le milieu de sortie 5 (puisque les coefficients $T_{TE}$ et $T_{TM}$ sont quasiment égaux à 1), et cela presque jusqu'à l'angle d'incidence correspondant à la réflexion totale interne, aussi bien pour une polarisation de type TE que pour une polarisation de type TM (à condition d'avoir choisi la valeur du facteur de remplissage FF adaptée à la polarisation considérée).

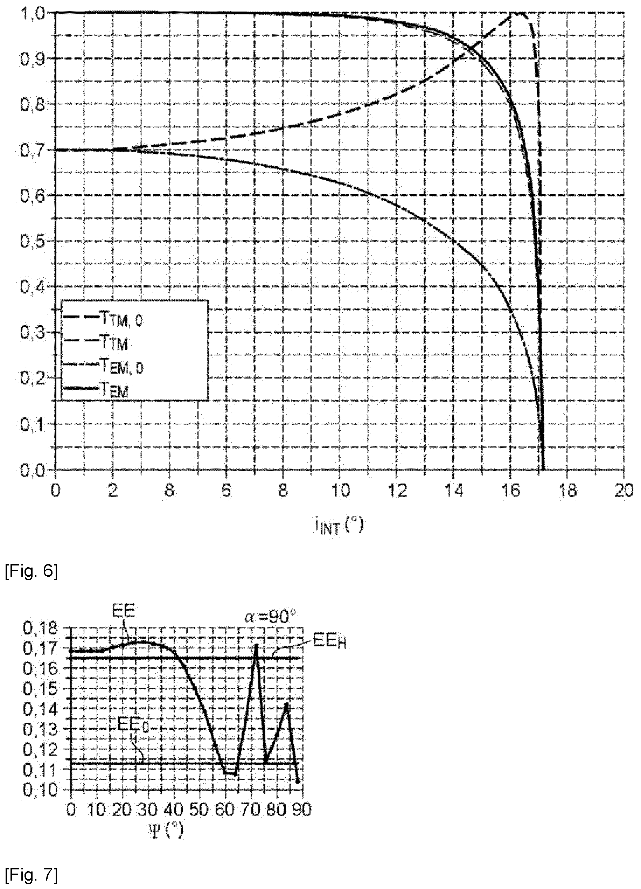

Les figures 6, 7 et 8 montrent quant à elles les valeurs de l'efficacité d'extraction EE du dispositif de figure 1, pour une polarisation de type TM (les résultats sont comparables pour une polarisation de type TE), pour différentes valeurs de la profondeur D du réseau. L'efficacité d'extraction est égale au rapport entre :

- d'une part, la puissance totale transmise finalement dans le milieu de sortie, dans un cône de collection centré sur l'axe Z et de demi-ouverture angulaire α (ouverture angulaire totale de 2α), et

- d'autre part, la puissance totale émise initialement, au sein de la structure émissive 2.

Les figures 6, 7 et 8 correspondent respectivement aux valeurs suivantes d'ouverture angulaire α du cône de collection : 90° (i.e. : intégration sur tout le demi-espace occupé par le milieu de sortie 5), 30° et 15°.

Sur chacune de ces figures, la profondeur D du réseau est représentée par la quantité ψ (plutôt que D), exprimée en degrés, où $D = λ/(4.n_{ARC,TM}. \cos(ψ))$.

Les résultats présentés sur ces figures ont été obtenus par simulation numérique de type FDTD (pour « Finite-Difference Time-Domain » en anglais), pour les mêmes paramètres que ceux de la figure 5, sauf en ce qui concerne la profondeur D du réseau, qui varie, ici.

Sur les figures 6 à 8, on a représenté aussi :

- l'efficacité d'extraction $EE_o$ pour une interface n=3,4 / $n_{out}$=1 nue, sans aucune structure antireflet, respectivement pour les trois valeurs de l'angle d'ouverture (angle de collection) α, et

- l'efficacité d'extraction $EE_H$ obtenue pour une couche antireflet homogène, formée d'un matériau (théorique) dont l'indice, uniforme, vaut $\sqrt{n.n_{out}}$, et d'épaisseur égale à $λ/\left(4\sqrt{n.n_{out}}\right)$.

Sur ces figures, on constate tout d'abord qu'une profondeur du réseau égale à $\lambda/(4.n_{ARC,TM})$ correspond effectivement à la profondeur optimale (ou quasi-optimale) en termes d'efficacité d'extraction (il s'agit du cas $\psi=0°$, sur les figures). On constate aussi que le réseau anti-reflet sub-longueur d'onde décrit ici permet d'obtenir une efficacité extraction aussi bonne, et même meilleure que le milieu homogène idéal mentionné ci-dessus, et cela pour les trois valeurs d'angle de collection considéré. L'efficacité d'extraction de ce réseau est donc très bonne, d'autant plus que la condition optimale $n_{couche} = \sqrt{n.n_{out}}$ n'est en général pas satisfaite, pour une couche antireflet homogène réelle (le choix de matériaux envisageables étant limité, en pratique).

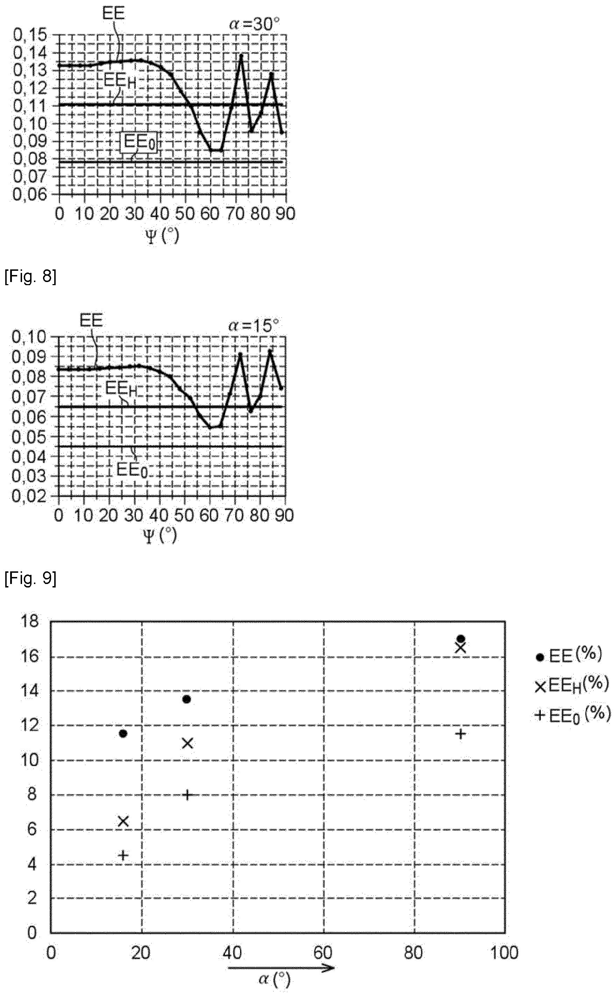

L'efficacité d'extraction EE correspondant à $D = \lambda/(4.n_{ARC,TM})$, l'efficacité d'extraction $EE_H$, et l'efficacité d'extraction $EE_o$ de l'interface nue sont reportées sur la figure 9, en fonction de l'angle $\alpha$ (exprimé en degrés).

On peut remarquer sur cette courbe que, pour $\alpha=90°$, l'efficacité d'extraction EE est égale à environ 1,5 fois $EE_o$, alors que pour $\alpha=15°$, elle est égale à environ 2,5 fois $EE_o$, ce qui montre bien que le rayonnement finalement émis dans le milieu de sortie est plus directif (plus resserré autour de l'axe Z) avec le réseau en question que pour une interface nue.

De même, pour $\alpha=90°$, l'efficacité d'extraction EE est égale à environ 1,03 fois $EE_H$, alors que pour $\alpha=15°$, elle est égale à environ 1,8 fois $EE_o$, ce qui montre aussi que le rayonnement finalement émis dans le milieu de sortie est plus directif avec le réseau en question qu'avec une couche anti-reflet homogène.

On remarque d'ailleurs que le rapport $EE_H/EE_o$ est, au contraire, sensiblement le même pour $\alpha=90°$, et pour $\alpha=15°$ (en l'occurrence égal à 1,4 environ), la couche anti-reflet homogène ne modifiant a priori pas, ou peu, la directivité du rayonnement émis, par rapport à une interface nue.

La figure 12 représente schématiquement des étapes, S1 et S2 d'un procédé de fabrication d'un dispositif opto-électronique tel que celui de la figure 1.

L'étape S1 est une étape de réalisation d'une structure émissive 2, telle que celle décrite plus haut, dont une partie au moins est formée d'un ou plusieurs matériaux semi-conducteurs, configurée pour produire un rayonnement lumineux lorsqu'elle est traversée par un courant électrique, ledit rayonnement lumineux étant produit au sein de la structure émissive et ayant une longueur d'onde moyenne $\lambda$, la structure émissive ayant un indice optique moyen n et étant délimitée par une surface de sortie 4, par laquelle sort une partie au moins dudit rayonnement lumineux. Cette étape, réalisée selon des techniques connues, n'est pas décrite plus en détail.

Quant à l'étape S2, il s'agit d'une étape de réalisation d'une structure anti-reflet 3, telle que décrite plus haut, située au niveau de la surface de sortie (4). Au cours de cette étape, on réalise donc un réseau 8 ; 8' ; 8" périodique sub-longueur d'onde qui comporte des parties en creux 7 ; 7' ; 7" et des parties en saillie 6 ; 6' ; 6" formant une structure périodique régulière de pas a inférieur à $\lambda/[2.n]$.

Dans ce procédé, à l'issu de l'étape S1, la structure émissive 2 présente une face supérieure plane. Et, à l'étape S2, le réseau 8 est réalisé par lithographie électronique puis gravure de cette face supérieure. Cette étape de gravure peut être typiquement réalisée par gravure ionique réactive (RIE pour reactive ion ecthing, en anglais) ou de manière moins standard par sonde ionique focalisée (FIB pour focused ion beam, en anglais).

## Revendications

1. Dispositif (1 ; 1' ; 1") opto-électronique comprenant :

   - une structure émissive (2)

     o dont une partie au moins est formée d'un ou plusieurs matériaux semi-conducteurs,
     o configurée pour produire un rayonnement lumineux lorsqu'elle est traversée par un courant électrique, ledit rayonnement lumineux étant produit au sein de la structure émissive (2) et ayant une longueur d'onde moyenne $\lambda$,
     o la structure émissive (2) ayant un indice optique moyen n et étant délimitée par une surface de sortie (4), par laquelle sort une partie au moins dudit rayonnement lumineux, et

     - une structure anti-reflet (3), située au niveau de la surface de sortie (4),
     - **caractérisé en ce que** la structure anti-reflet (3) comprend un réseau (8 ; 8' ; 8") périodique sub-longueur d'onde qui comporte des parties en creux (7 ; 7' ; 7") et des parties en saillie (6 ; 6' ; 6") formant une structure périodique régulière de pas (a) inférieur à $\lambda/[2.n]$.

2. Dispositif (1 ; 1' ; 1") selon la revendication 1, dans lequel l'aire occupée par la surface de sortie (4) de la structure émissive (2) est inférieure à 50 $\mu m^2$, voire inférieure à 5 $\mu m^2$.

3. Dispositif (1 ; 1' ; 1") selon la revendication 1 ou 2, dans lequel la structure émissive (2) comporte une couche supérieure superficielle, formée d'un matériau semi-conducteur, et dans lequel les parties en saillie (6 ; 6' ; 6") dudit réseau (8 ; 8' ; 8"), formées du même matériau semi-conducteur que ladite couche supérieure superficielle, sont d'un seul tenant avec la couche supérieure de la structure émissive.

4. Dispositif (1 ; 1' ; 1") selon l'une des revendications précédentes, dans lequel :

   - les parties en saillie (6 ; 6' ; 6") du réseau sont formées d'un matériau ayant un indice optique $n_p$,
   - un milieu (5) d'indice optique $n_{out}$ s'étend au-dessus du réseau, à l'opposé de la structure émissive (2),
   - un milieu d'indice $n_r$ remplit les parties en creux (7 ; 7' ; 7") du réseau, et dans lequel
   - un facteur de remplissage FF du réseau, égal à la fraction du volume du réseau occupé par ses parties en creux (7 ; 7' ; 7"), est égal au facteur de remplissage $FF_{TE}$ donné par la formule F1 suivante :

$$\sqrt{FF_{TE}.n_r^2 + (1 - FF_{TE}).n_p^2} = \sqrt{n.n_{out}} \qquad (F1).$$

5. Dispositif (1) selon la revendication 4, dans lequel le réseau (8) est unidimensionnel, les parties en creux (7) étant des rainures rectilignes parallèles entre elles, et dans lequel ledit rayonnement a une polarisation substantiellement rectiligne, et parallèle auxdites rainures (7).

6. Dispositif (1' ; 1") selon la revendication 4, dans lequel le réseau (8' ; 8") est un réseau bidimensionnel comportant un motif (7' ; 7") répété périodiquement selon une première direction (X), et répété aussi, périodiquement, selon une deuxième direction (Y ; Y") différente de la première direction.

7. Dispositif (1) selon l'une des revendications 1 à 3, dans lequel,

   - les parties en saillie (6) du réseau sont formées d'un matériau ayant un indice optique $n_p$,
   - un milieu (5) d'indice optique $n_{out}$ s'étend au-dessus du réseau (8), à l'opposé de la structure émissive (2),
   - un milieu d'indice $n_r$ remplit les parties en creux (7) du réseau,
   - le réseau (8) est unidimensionnel, les parties en creux (7) étant des rainures rectilignes parallèles entre elles, et ledit rayonnement a une polarisation substantiellement rectiligne et perpendiculaire auxdites rainures, et dans lequel
   - un facteur de remplissage FF du réseau, égal à la fraction du volume du réseau occupé par ses parties en creux (7), est égal au facteur de remplissage $FF_{TM}$ donné par la formule F2 suivante :

$$\sqrt{\left(FF_{TM}.n_r^{-2} + (1 - FF_{TM}).n_p^{-2}\right)^{-1}} = \sqrt{n.n_{out}} \qquad (F2).$$

8. Dispositif (1 ; 1' ; 1") selon l'une des revendications précédentes, dans lequel le réseau (8 ; 8' ; 8") a une profondeur D, selon une direction (z) perpendiculaire à la surface de sortie (4), la profondeur D étant égale à $\lambda / \left(4\sqrt{n.n_{out}}\right)$, $n_{out}$ étant l'indice optique du milieu (5) qui s'étend au-dessus du réseau, à l'opposé de la structure émissive (2).

9. Dispositif (1 ; 1' ; 1") selon l'une des revendications précédentes, le dispositif étant une diode électroluminescente, dans lequel la structure émissive (2) comprend :

   - une couche inférieure (22), formée au moins en partie d'un semi-conducteur dopé,
   - une couche supérieure (21), formée au moins en partie d'un semiconducteur dopé, les couches inférieure et supérieure ayant des dopages de types opposés, et
   - une partie émissive (23), qui s'étend entre la couche inférieure et la couche supérieure et qui est apte à émettre ledit rayonnement lumineux lorsqu'elle est traversée par un courant électrique.

10. Ecran d'affichage comprenant une matrice de dispositifs opto-électroniques (1 ; 1' ; 1") conformes chacun à l'une des revendications précédentes.

11. Procédé de fabrication d'un dispositif opto-électronique (1 ; 1' ; 1"), comprenant :

- une étape (S1) de réalisation d'une structure émissive (2) dont une partie au moins est formée d'un ou plusieurs matériaux semi-conducteurs, configurée pour produire un rayonnement lumineux lorsqu'elle est traversée par un courant électrique, ledit rayonnement lumineux étant produit au sein de la structure émissive (2) et ayant une longueur d'onde moyenne λ, la structure émissive ayant un indice optique moyen n et étant délimitée par une surface de sortie (4), par laquelle sort une partie au moins dudit rayonnement lumineux, et
- une étape (S2) de réalisation d'une structure anti-reflet (3), située au niveau de la surface de sortie (4),
- le procédé étant **caractérisé en ce que** l'étape (2) de réalisation de la structure anti-reflet (3) comprend une étape de réalisation d'un réseau (8 ; 8' ; 8") périodique sub-longueur d'onde qui comporte des parties en creux (7 ; 7' ; 7") et des parties en saillie (6 ; 6' ; 6") formant une structure périodique régulière de pas (a) inférieur à λ/[2.n].

**12.** Procédé selon la revendication précédente, dans lequel la structure émissive (2) présente, à l'issu de l'étape (S1) de réalisation de cette structure, une face supérieure libre, et dans lequel le réseau (8 ; 8' ; 8") est réalisé par lithographie électronique puis gravure de ladite face supérieure.


**Patentansprüche**

**1.** Optoelektronische Vorrichtung (1; 1'; 1") mit:

- einer emittierenden Struktur (2)

  o deren mindestens ein Teil aus einem oder mehreren Halbleitermaterialien besteht,
  o die so gestaltet ist, dass sie eine Lichtstrahlung erzeugt, wenn sie von einem elektrischen Strom durchflossen wird, wobei die Lichtstrahlung innerhalb der emittierenden Struktur (2) erzeugt wird und eine mittlere Wellenlänge λ hat
  o wobei die emittierende Struktur (2) einen mittleren optischen Index n aufweist und von einer Austrittsfläche (4) begrenzt wird, durch die zumindest ein Teil der Lichtstrahlung austritt, und

- einer Antireflexionsstruktur (3), die sich an der Austrittsfläche (4) befindet,
- **dadurch gekennzeichnet, dass** die Antireflexionsstruktur (3) ein periodisches Subwellenlängengitter (8; 8'; 8") umfasst, das vertiefte Abschnitte (7; 7'; 7") und vorstehende Abschnitte (6; 6'; 6") umfasst, die eine regelmäßige periodische Struktur mit einer Teilung (a) von weniger als λ /[2.n] bilden.

**2.** Vorrichtung (1; 1'; 1") nach Anspruch 1, bei der die Fläche, die von der Austrittsfläche (4) der emittierenden Struktur (2) eingenommen wird, kleiner als 50 $\mu m^2$ oder sogar kleiner als 5 $\mu m^2$ ist.

**3.** Vorrichtung (1; 1'; 1") nach Anspruch 1 oder 2, bei der die emittierende Struktur (2) eine obere Oberflächenschicht aufweist, die aus einem Halbleitermaterial gebildet ist, und bei der die vorstehenden Abschnitte (6; 6'; 6") des Gitters (8; 8'; 8"), die aus demselben Halbleitermaterial wie die obere Oberflächenschicht gebildet sind, einstückig mit der oberen Schicht der emittierenden Struktur sind.

**4.** Vorrichtung (1; 1'; 1") nach einem der vorhergehenden Ansprüche, bei der:

- die vorstehenden Abschnitte (6; 6'; 6") des Gitters aus einem Material mit einem optischen Index $n_p$ gebildet sind,
- ein Medium (5) mit dem optischen Index $n_{out}$ sich oberhalb des Gitters erstreckt, gegenüber der emittierenden Struktur (2),
- ein Medium mit dem Index $n_r$ die vertieften Abschnitte (7; 7'; 7") des Gitters füllt, und bei der
- ein Füllfaktor FF des Gitters, der gleich dem Bruchteil des Volumens des Gitters ist, der von seinen vertieften Abschnitten (7; 7'; 7") eingenommen wird, gleich dem Füllfaktor $FF_{TE}$ ist, der durch die folgende Formel F1 gegeben ist:

$$\sqrt{FF_{TE}.n_r^2 + (1 - FF_{TE}).n_p^2} = \sqrt{n.n_{out}} \qquad (F1)$$

**5.** Vorrichtung (1) nach Anspruch 4, bei der das Gitter (8) eindimensional ist, wobei die vertieften Abschnitte (7) geradlinige Rillen sind, die parallel zueinander verlaufen, und bei der die Strahlung eine im Wesentlichen geradlinige Polarisation hat, die parallel zu den Rillen (7) verläuft.

**6.** Vorrichtung (1'; 1") nach Anspruch 4, bei der das Gitter (8'; 8") ein zweidimensionales Gitter ist, das ein Muster (7'; 7") umfasst, das periodisch in einer ersten Richtung (X) wiederholt wird und auch periodisch in einer zweiten Richtung (Y; Y") wiederholt wird, die sich von der ersten Richtung unterscheidet.

**7.** Vorrichtung (1) nach einem der Ansprüche 1 bis 3, bei der,

- die vorstehenden Abschnitte (6) des Gitters aus einem Material mit einem optischen Index $n_p$ gebildet werden,
- ein Medium (5) mit dem optischen Index $n_{out}$ sich über das Gitter (8) erstreckt, gegenüber der emittierenden Struktur (2),
- ein Medium mit dem Index $n_r$ die vertieften Abschnitte (7) des Gitters füllt,
- das Gitter (8) eindimensional ist, wobei die vertieften Abschnitte (7) geradlinige, zueinander parallele Rillen sind, und die Strahlung eine im Wesentlichen geradlinige und zu den Rillen senkrechte Polarisation aufweist, und bei der
- ein Füllfaktor FF des Gitters, der gleich dem Bruchteil des Volumens des Gitters ist, das von seinen vertieften Abschnitten (7) eingenommen wird, gleich dem Füllfaktor $FF_{TM}$ ist, der durch die folgende Formel F2 gegeben ist:

$$\sqrt{\left(FF_{TM}.n_r^{-2} + (1 - FF_{TM}).n_p^{-2}\right)^{-1}} = \sqrt{n.n_{out}} \qquad (F2)$$

**8.** Vorrichtung (1; 1'; 1") nach einem der vorhergehenden Ansprüche, bei der das Gitter (8; 8'; 8") eine Tiefe D in einer Richtung (z) senkrecht zur Austrittsfläche (4) aufweist, wobei die Tiefe D gleich $\lambda/\left(4\sqrt{n.n_{out}}\right)$ ist, wobei $n_{out}$ der optische Index des Mediums (5) ist, das sich über das Gitter erstreckt, gegenüber der emittierenden Struktur (2).

**9.** Vorrichtung (1; 1'; 1") nach einem der vorhergehenden Ansprüche, bei der die Vorrichtung eine lichtemittierende Diode ist, in der die emittierende Struktur (2) umfasst:

- eine untere Schicht (22), die zumindest teilweise aus einem dotierten Halbleiter gebildet wird,
- eine obere Schicht (21), die zumindest teilweise aus einem dotierten Halbleiter gebildet wird, wobei die untere und die obere Schicht Dotierungen entgegengesetzter Art aufweisen, und
- einen emittierenden Abschnitt (23), der sich zwischen der unteren Schicht und der oberen Schicht erstreckt und die Lichtstrahlung emittieren kann, wenn er von einem elektrischen Strom durchflossen wird.

**10.** Anzeigebildschirm mit einer Matrix aus optoelektronischen Vorrichtungen (1; 1'; 1"), die jeweils einem der vorhergehenden Ansprüche entsprechen.

**11.** Verfahren zur Herstellung einer optoelektronischen Vorrichtung (1; 1'; 1"), umfassend:

- einen Schritt (S1) zur Herstellung einer emittierenden Struktur (2), von der zumindest ein Abschnitt aus einem oder mehreren Halbleitermaterialien gebildet ist, der so gestaltet ist, dass er Lichtstrahlung erzeugt, wenn er von einem elektrischen Strom durchflossen wird, wobei die Lichtstrahlung innerhalb der emittierenden Struktur (2) erzeugt wird und eine mittlere Wellenlänge $\lambda$ hat, wobei die emittierende Struktur einen mittleren optischen Index n hat und durch eine Austrittsfläche (4) begrenzt ist, durch die zumindest ein Teil der Lichtstrahlung austritt, und
- einen Schritt (S2) zur Herstellung einer Antireflexionsstruktur (3), die sich an der Austrittsfläche (4) befindet,
- wobei das Verfahren **dadurch gekennzeichnet ist, dass** der Schritt (2) zur Herstellung der Antireflexionsstruktur (3) einen Schritt zur Herstellung eines periodischen Subwellenlängengitters (8; 8'; 8") umfasst, das vertiefte Abschnitte (7; 7'; 7") und vorspringende Abschnitte (6; 6'; 6") umfasst, die eine regelmäßige periodische Struktur mit einer Teilung (<u>a</u>) von weniger als $\lambda$/[2.n] bilden.

**12.** Verfahren nach dem vorhergehenden Anspruch, bei dem die emittierende Struktur (2) nach dem Schritt (S1) der Herstellung dieser Struktur eine freie Oberseite aufweist, und bei dem das Gitter (8; 8'; 8") durch Elektronenstrahllithographie und anschließendes Ätzen der Oberseite hergestellt wird.

**Claims**

**1.** An optoelectronic device (1; 1'; 1") comprising:

- an emissive structure (2)

   ◦ at least a part of which is formed of one or more semiconductor materials,
   o configured to produce a luminous radiation when it has an electric current flowing therethrough, said luminous radiation being produced within the emissive structure (2) and having an average wavelength $\lambda$,
   o the emissive structure (2) having an average optical index n and being delimited by an outlet surface (4), through which at least a part of said luminous radiation exits, and

- an antireflective structure (3), located at the outlet surface (4),
- **characterised in that** the antireflective structure (3) comprises a sub-wavelength periodic grating (8; 8'; 8") which includes hollow parts (7; 7'; 7") and protruding parts (6; 6'; 6") forming a regular periodic structure with a pitch (<u>a</u>) lower than $\lambda/[2.n]$.

2. The device (1; 1'; 1") according to claim 1, wherein the area occupied by the outlet surface (4) of the emissive structure (2) is lower than 50 $\mu m^2$, or even lower than 5 $\mu m^2$.

3. The device (1; 1'; 1") according to claim 1 or 2, wherein the emissive structure (2) includes a superficial upper layer, formed of a semiconductor material, and wherein the protruding parts (6; 6'; 6") of said grating (8; 8'; 8"), formed of the same semiconductor material as said superficial upper layer, are as one piece with the upper layer of the emissive structure.

4. The device (1; 1'; 1") according to one of the preceding claims, wherein:

   - the protruding parts (6; 6'; 6") of the grating are formed of a material having an optical index $n_p$,
   - a medium (5) of optical index $n_{out}$ extends above the grating, opposite to the emissive structure (2),
   - a medium of index $n_r$ fills the hollow parts (7; 7'; 7") of the grating, and wherein
   - a filling factor FF of the grating, equal to the fraction of the volume of the grating occupied by its hollow parts (7; 7'; 7"), is equal to the filling factor $FF_{TE}$ given by the following formula F1:

$$\sqrt{FF_{TE}.n_r^2 + (1 - FF_{TE}).n_p^2} = \sqrt{n.n_{out}} \quad \text{(F1)}.$$

5. The device (1) according to claim 4, wherein the grating (8) is one-dimensional, the hollow parts (7) being rectilinear grooves parallel to each other, and wherein said radiation has a substantially rectilinear polarisation, and parallel to said grooves (7).

6. The device (1'; 1") according to claim 4, wherein the grating (8'; 8") is a two-dimensional grating including a pattern (7'; 7") periodically repeated along a first direction (X), and also periodically repeated along a second direction (Y; Y") different from the first direction.

7. The device (1) according to one of claims 1 to 3, wherein,

   - the protruding parts (6) of the grating are made of a material having an optical index $n_p$,
   - a medium (5) of optical index $n_{out}$ extends above the grating (8), opposite to the emissive structure (2),
   - a medium of index $n_r$ fills the hollow parts (7) of the grating,
   - the grating (8) is one-dimensional, the hollow parts (7) being rectilinear grooves parallel to each other, and said radiation has a substantially rectilinear polarisation perpendicular to said grooves, and wherein
   - a filling factor FF of the grating, equal to the fraction of the volume of the grating occupied by its hollow parts (7), is equal to the filling factor $FF_{TM}$ given by the following formula F2:

$$\sqrt{\left(FF_{TM}.n_r^{-2} + (1 - FF_{TM}).n_p^{-2}\right)^{-1}} = \sqrt{n.n_{out}} \quad \text{(F2)}.$$

8. The device (1; 1'; 1") according to one of the preceding claims, wherein the grating (8; 8'; 8") has a depth D, along a direction (z) perpendicular to the outlet surface (4), the depth D being equal to $\lambda/\left(4\sqrt{n.n_{out}}\right)$, $n_{out}$ being the optical index of the medium (5) which extends above the grating, opposite to the emissive structure (2).

9. The device (1; 1'; 1") according to one of the preceding claims, the device being a light-emitting diode, wherein the emissive structure (2) comprises:

- a lower layer (22), formed at least in part of a doped semiconductor,
- an upper layer (21), formed at least in part of a doped semiconductor, the lower and upper layers having opposite type doping, and
- an emissive part (23), which extends between the lower layer and the upper layer and which is capable of emitting said luminous radiation when it has an electric current flowing therethrough.

10. A display screen comprising an array of optoelectronic devices (1; 1'; 1") each in accordance with one of the preceding claims.

11. A method for manufacturing an optoelectronic device (1; 1'; 1"), comprising:

- a step (S1) of making an emissive structure (2), at least a part of which is formed of one or more semiconductor materials, configured to produce a luminous radiation when it has an electric current flowing therethrough, said luminous radiation being produced within the emissive structure (2) and having an average wavelength $\lambda$, the emissive structure having an average optical index n and being delimited by an outlet surface (4), through which at least a part of said luminous radiation exits, and
- a step (S2) of making an antireflective structure (3), located at the outlet surface (4),
- the method being **characterised in that** the step (2) of making the antireflective structure (3) comprises a step of making a sub-wavelength periodic grating (8; 8'; 8") which includes hollow parts (7; 7'; 7") and protruding parts (6; 6'; 6") forming a regular periodic structure with a pitch (a) lower than $\lambda/[2.n]$.

12. The method according to the preceding claim, wherein the emissive structure (2) has, at the end of the step (S1) of making this structure, a free upper face, and wherein the grating (8; 8'; 8") is made by electron lithography and then etching of said upper face.

[Fig. 1]

[Fig. 2]

[Fig. 3]

$3_{eq}$ {  $n_{ARC,TE}$ / $n_{ARC,TM}$   D

$Z_e$

Z
⊗ TE
→ TM

Z
⊗ Y → X

[Fig. 4]

1

7 7 7   8

Y

Z ⊙ → X

a

[Fig. 5]

[Fig. 6]

[Fig. 7]

[Fig. 8]

[Fig. 9]

[Fig. 10]

[Fig. 11]

[Fig. 12]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2014211302 A1

- US 7145721 B2

**Littérature non-brevet citée dans la description**

- **HEE KWAN LEE et al.** Improved Device Performance of AlGaInP-Based Vertical Light-Emitting Diodes with Low-n ATO Antireflective Coating Layer. *Microelectronic Engineering*, 01 April 2013, vol. 104, 29-32